# EUROPEAN PATENT APPLICATION

(11) **EP 3 309 723 A1**
(43) Date of publication of application: **18.04.2018**
(21) Application number: 16193189.4
(22) Date of filing: 11.10.2016
(51) Int. Cl.: G06Q 10/06, G06Q 10/08

(54) **AN ENGINEERING METHOD, SYSTEM, AND COMPUTER PROGRAM PRODUCT**

(71) Applicant: Siemens Aktiengesellschaft, 80333 München (DE)
(72) Inventor: GUPTA, Rohit Kumar, 122015 Gurgaon, Haryana (IN)
(74) Representative: Isarpatent

(57) **Abstract**

An engineering method, an engineering management system (103) comprising a token database (106) connected to a plurality of external sources (107) via a communication network (108), and a computer program product are provided. The engineering management system (103) determines a connection of at least one engineering object (102) into a communication network (104) of a plurality of engineering objects (101A-101F) by obtaining token data associated with the engineering object (102). The engineering management system (103) determines an automation function instance (501) of the engineering object (102), from a plurality of automation function instances (501-505) stored in an engineering database (105), based on the token data. The engineering management system (103) generates an engineering recommendation (500A) based on the automation function instance (501), comprising proposed connections of the automation function instance (501) with other automation function instances (502-505). The engineering management system (103) performs engineering based on the engineering recommendation (500A) for the automation function instance (501) of the engineering object (102).

## Description

The present invention relates to performing engineering in a distributed control system environment, and more particularly to an engineering method employing an engineering management system for performing the engineering.

Conventionally, in a distributed control system, performing engineering, for example, configuring different processes in a manufacturing plant, involves contribution from experts possessing domain knowledge of various types of equipment that are a part of such engineering. Moreover, performance of such engineering is largely dependent on experts referring manually to the engineering data associated with the equipment, selecting automation function instances, that is, logical representations, for the equipment and manually configuring the engineering in the distributed control system. However, failure to automatically configure and perform the engineering, typically results in engineering errors due to lack of verification and validation performed, of the engineering, while a process or a product is being engineered and while the engineering is being implemented in real time. Moreover, failure to automatically perform the engineering configuration also leads to an increase in the time, the cost and the effort required for performing such engineering, thereby affecting an overall operational efficiency of the distributed control system.

Furthermore, in scenarios of a downtime, maintenance or equipment replacement, where new equipment is inserted into the distributed control system, the conventional engineering methods and systems fail to automatically update configuration of the engineering, for example, a software configuration or a network configuration, etc., for incorporating the newly inserted equipment, as these conventional engineering methods and systems mainly rely on manual configuration of the process. This typically leads to increased maintenance costs.

Therefore, it is an object of the present invention to provide an engineering method, an engineering management system, and a computer program product for performing engineering with an enhanced accuracy, in a time and a cost effective manner.

The method and system according to the present invention achieve the aforementioned object by determining a connection of at least one engineering object into a communication network of a plurality of engineering objects by obtaining token data associated with the engineering object, determining an automation function instance of the engineering object from a plurality of automation function instances stored in an engineering database, based on the token data, generating an engineering recommendation based on the automation function instance, comprising proposed connections of the automation function instance with other automation function instances, and performing engineering based on the engineering recommendation for the automation function instance of the engineering object.

According to the present invention, an engineering method employing an engineering management system is provided. The engineering method, according to the present invention, comprises determining a connection of at least one engineering object into a communication network of a plurality of engineering objects by obtaining token data associated with the engineering object. As used herein, "engineering object" refers to an industrial component comprising, for example, field devices and field components such as sensors, actuators, transmitters, multiplexers, control room devices, compact controllers, etc. The communication network is, for example, a wired network, a wireless network, or a network formed from any combination of these networks. The communication network is, for example, a plant bus, a field bus, a communication bus, etc. via which a plurality of engineering objects, that is, field devices or field components communicate with each other. Also used herein, "token data" refers to data associated with configuration of the engineering objects in the distributed control system. The token data comprises data associated with configuration and/or manufacturing of the engineering object. The token data comprises, for example, a device type, a unique identification code, manufacturing data such as a serial number, a manufacture code, a model number, etc. According to a preferred embodiment of the present invention, the engineering method comprises generating a unique identification code and assigning it to the engineering object when the engineering object is inserted into the communication network. According to another embodiment of the present invention, the unique identification code is assigned by a user accessing the engineering management system, for example, a network administrator, when the engineering object is inserted into the communication network.

According to a preferred embodiment of the present invention, the engineering method obtains the token data by periodically monitoring the communication network for receiving the token data from the engineering object. The token data is stored in the engineering objects and comprises information such as device type, device make, etc., which the engineering method receives from the engineering object. According to another embodiment of the present invention, the engineering method obtains the token data for the engineering object from a token database storing the token data associated with a plurality of engineering objects, based on, for example, a type, a name, etc., of the engineering object. According to a preferred embodiment of the present invention, the token database is in communication with a plurality of external sources over a communication network. The external sources comprise, for example, vendor applications, enterprise resource planning systems, manufacturer websites, etc., using which the token database updates and maintains the token data for the engineering objects. According to another embodiment of the present invention, the token database is configured as a cloud based database implemented in a cloud computing environment, where computing resources are delivered as a service over a communication network. As used herein, "cloud computing environment" refers to a processing environment comprising configurable computing physical and logical resources, for example, networks, servers, storage, applications, services, etc., and data distributed over the communication network, for example, the internet. The cloud computing environment provides on-demand network access to a shared pool of the configurable computing physical and logical resources.

The engineering method, according to the present invention, comprises determining an automation function instance of the engineering object, from a plurality of automation function instances stored in an engineering database, based on the token data. As used herein, "automation function instance" refers to a logical representation of the engineering object used, for example, in configuring software communication between the engineering objects. The automation function instance comprises data associated with the engineering object such as an internet protocol (IP) address of the engineering object, connection ports such as an input port, an output port, etc. According to an embodiment of the present invention, the engineering database is configured as a cloud based database implemented in a cloud computing environment. The engineering method, according to the present invention, extracts one or more configuration parameters from the token data associated with an engineering object, compares these configuration parameters with the automation function instances stored in the engineering database, in order to determine an automation function instance for the engineering object. According to a preferred embodiment of the present invention, the engineering method comprises creating an automation function instance based on the token data, when an automation function instance for the engineering object is absent in the engineering database. According to another preferred embodiment of the present invention, the engineering method comprises recommending an alternative automation function instance, when an automation function instance for the engineering object is absent in the engineering database. In this embodiment, the engineering method determines an automation function instance that includes data which is a closest match to the token data of the engineering object. According to another embodiment of the present invention, the engineering method receives a user input for selection of the automation function instance when an automation function instance for the engineering object is absent in the engineering database. According to another embodiment of the present invention, the engineering method receives a user input for confirming the determined automation function instance for the engineering object.

The engineering method, according to the present invention, comprises generating an engineering recommendation based on the automation function instance, wherein the engineering recommendation comprises proposed connections of the automation function instance with other automation function instances. According to an embodiment of the present invention, the engineering method generates the engineering recommendation based on historical data comprising, for example, an engineering performed in the distributed control system using the engineering object that the automation function instance represents. According to another embodiment of the present invention, the engineering method generates the engineering recommendation based on a user input. According to a preferred embodiment of the present invention, the engineering recommendation comprises a proposed position of insertion of the automation function instance with respect to other automation function instances. According to another embodiment of the present invention, the engineering method receives a user input to verify and validate the proposed position of insertion of the automation function instance. According to a preferred embodiment of the present invention, the engineering method stores the engineering recommendation in the engineering database, which can be retrieved when the engineering object is re-inserted into the communication network.

The engineering method, according to the present invention, comprises performing engineering based on the engineering recommendation for the automation function instance of the engineering object using the engineering management system.

As used herein, the term "engineering" refers to one or more of commissioning, configuring, for example, creating a configuration logic, implementing, executing, maintaining, troubleshooting etc., of one or more processes included in a distributed control system. Also, used herein, the term "processes" refers to one or more engineering objects performing certain operational objective, for example, a process of system shutdown comprising performing a safe shutdown of the distributed control system by operating one or more engineering objects, on occurrence of one or more events such as power outage, faults, etc., to ensure protection of the distributed control system under such occurrences.

According to a preferred embodiment of the present invention, the engineering method performs the engineering based on the engineering recommendation by obtaining a process layout diagram associated with the engineering recommendation, determining a position of insertion of the engineering object in the process layout diagram using the engineering recommendation, and connecting the engineering object in the process layout diagram at the position of insertion. As used herein, the "process layout diagram" comprises a plurality of engineering objects in connection with each other and represents a network configuration of the engineering objects that are in connection with one another. A process layout diagram comprises, for example, a network layout of various engineering objects, that is, process equipment involved in the engineering of the distributed control system along with process interlocks that preclude incorrect process operations thereby enabling prevention of damage to engineering objects of the distributed control system. According to an embodiment of the present invention, the engineering method maintains the process layout diagrams in the engineering database. According to another embodiment of the present invention, the engineering method obtains the process layout diagrams from the external sources via the communication network.

The engineering method, according to an embodiment of the present invention, accesses the token database and the engineering database via a network attached storage device. As used herein, "network attached storage device" refers to an electronic device that is capable of storing data, for example, the token data, the automation function instances, the engineering recommendations, the process layout diagrams etc., and is connected to the communication network. According to another embodiment of the present invention the token database and the engineering database are comprised in one common database, for example, a distributed control system database which the engineering method accesses via a communication network, a cloud computing environment, and/or a network attached storage device. According to another embodiment of the present invention, the token database and the engineering database reside on the engineering management system.

According to the present invention, also disclosed herein is an engineering management system. The engineering management system comprises a token database configured to store token data associated with at least one engineering object. The token database is connected to a plurality of external sources via a communication network. The engineering management system further comprises a non-transitory computer readable storage medium storing computer program instructions defined by modules of the engineering management system and at least one processor communicatively coupled to the non-transitory computer readable storage medium, executing the defined computer program instructions. The modules of the engineering management system comprise a connection determination module, an automation function instance management module, a recommendation generation module, and an engineering performing module. The connection determination module determines connection of the engineering object into a communication network of a plurality of engineering objects by obtaining the token data. The automation function instance management module determines an automation function instance of the engineering object, from a plurality of automation function instances stored in an engineering database, based on the token data. The recommendation generation module generates an engineering recommendation based on the automation function instance, wherein the engineering recommendation comprises proposed connections of the automation function instance with other automation function instances. The engineering performing module performs engineering based on the engineering recommendation for the automation function instance of the engineering object.

According to the present invention, also disclosed herein, is an engineering system, comprising the engineering management system with the token database, the engineering database connected to the engineering management system via a communication network, and a plurality of external sources connected to the token database of the engineering management system via a communication network.

According to the present invention, also disclosed herein, is a distributed control system comprising the engineering system and a plurality of engineering objects in connection with one another and with the engineering system via a communication network.

According to the present invention, also disclosed herein, is a distributed control system, comprising the engineering management system, the engineering database connected to the engineering management system via a communication network, a plurality of external sources connected to the token database of the engineering management system via a communication network, and a plurality of engineering objects in connection with one another and with the engineering management system via a communication network. According to an embodiment of the present invention, the distributed control system comprises a single communication network over which the engineering management system, the engineering objects, the engineering database and the external sources communicate with one another. According to another embodiment of the present invention, the distributed control system comprises separate communication networks facilitating communication between two or more of the engineering management system, the engineering objects, the engineering database and the external sources.

According to the present invention, also disclosed herein, is a computer program product comprising a non-transitory computer readable storage medium storing computer program codes that comprise instructions executable by at least one processor for performing the engineering method steps disclosed above.

The above-mentioned and other features of the invention will now be addressed with reference to the accompanying drawings of the present invention. The illustrated embodiments are intended to illustrate, but not limit the invention.

The present invention is further described hereinafter with reference to illustrated embodiments shown in the accompanying drawings, in which:
- FIG 1: illustrates a distributed control system comprising an engineering system in connection with a plurality of engineering objects via a communication network.
- FIG 2: illustrates an embodiment of an engineering management system of the engineering system illustrated in FIG 1.
- FIG 3: is a process flowchart illustrating an engineering method employing the engineering management system illustrated in FIGS 1 or 2.
- FIG 4: is a block diagram illustrating architecture of a computer system employed by the engineering management system illustrated in FIGS 1 or 2.
- FIGS 5A-5C: illustrate screenshots of a graphical user interface provided by the engineering management system illustrated in FIGS 1 or 2 on a user device for performing steps of the engineering method.

Various embodiments are described with reference to the drawings, wherein like reference numerals are used to refer to like elements throughout. In the following description, for the purpose of explanation, numerous specific details are set forth in order to provide thorough understanding of one or more embodiments of the present invention. It may be evident that such embodiments may be practiced without these specific details.

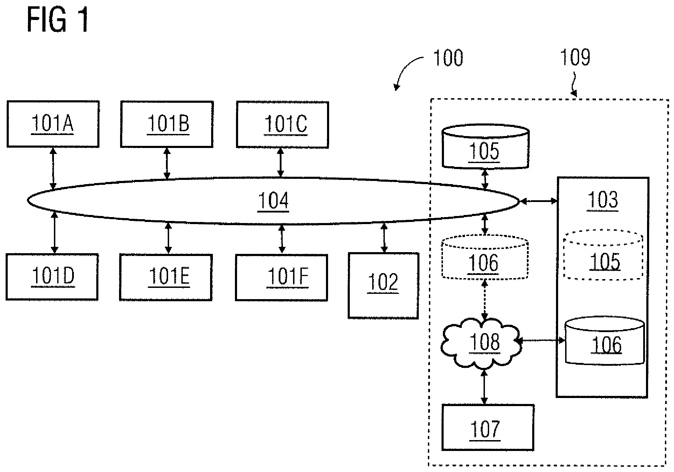

FIG 1 illustrates a distributed control system 100 comprising an engineering system 109 in connection with a plurality of engineering objects 101A-101F via a communication network 104. The communication network 104 is a plant bus network. The engineering system 109 as illustrated in FIG 1 comprises an engineering management system 103 with a token database 106. The engineering system 109 and/or the engineering management system 103 are accessible by a user device (not shown), for example, a personal computing device, a workstation, a client device, a network enabled computing device, any other suitable computing equipment, and combinations of multiple pieces of computing equipment. A user using the user device and accessing the engineering management system 103 inserts a new engineering object 102 into the communication network 104. The engineering system 109 comprises an engineering database 105 in connection with the engineering management system 103 via the communication network 104. The token database 106 of the engineering management system 103, is connected to a plurality of external sources 107 via a communication network 108. The communication network 108 comprises a cloud based network. The communication network 108 may also represent a network shared for Internet of Things (IoT). Each of the databases, the engineering database 105 and the token database 106, may reside either internal to or external to the energy management system 103 as illustrated in FIG 1.

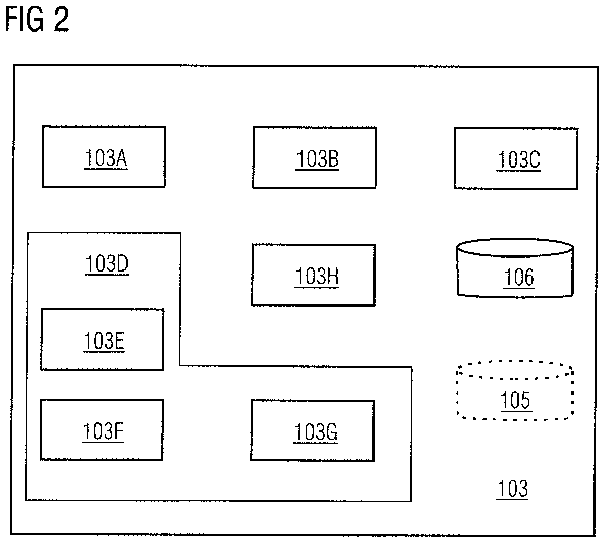

FIG 2 illustrates an embodiment of the engineering management system 103 of the engineering system 109 illustrated in FIG 1. The engineering management system 103 disclosed herein comprises a token database 106 configured to store token data associated with an engineering object 101A-101F, 102. The token data comprises data associated with configuration and/or manufacturing of the engineering objects 101A-101F, 102. The token database 106 is in communication with a plurality of external sources 107 via the communication network 108. The engineering management system 103 disclosed herein comprises a non-transitory computer readable storage medium and at least one processor communicatively coupled to the non-transitory computer readable storage medium. As used herein, "non-transitory computer readable storage medium" refers to all computer readable media, for example, non-volatile media, volatile media, and transmission media except for a transitory, propagating signal. The non-transitory computer readable storage medium is configured to store computer program instructions defined by modules, for example, 103A, 103B, 103C, 103D, 103E, 103F, 103G, etc., of the engineering management system 103. The processor is configured to execute the defined computer program instructions. As illustrated in FIG 2, the engineering management system 103 comprises a graphical user interface (GUI) 103H. A user using the user device can access the engineering management system 103 via the GUI 103H. The GUI 103H is, for example, an online web interface, a web based downloadable application interface such as Microsoft^{®} Windows^{®} application, etc. The engineering management system 103 further comprises a connection determination module 103A, an automation function instance management module 103B, a recommendation generation module 103C, and an engineering performing module 103D.

The connection determination module 103A determines connection of the engineering object 102 into the communication network 104 of a plurality of engineering objects 101A-101F by obtaining the token data. The connection determination module 103A periodically monitors the communication network 104 and obtains the token data from the engineering object 102, the token database 106, and/or the external sources 107. The automation function instance management module 103B determines an automation function instance of the engineering object 102, from a plurality of automation function instances stored in the engineering database 105, based on the token data. The automation function instance management module 103B creates an automation function instance, when the automation function instance for the engineering object 102 is absent in the engineering database 105. The automation function instance management module 103B recommends an alternative automation function instance, when the automation function instance for the engineering object 102 is absent in the engineering database 105.

The recommendation generation module 103C generates an engineering recommendation based on the automation function instance. The engineering recommendation comprises proposed connections of the automation function instance with other automation function instances. The engineering performing module 103D performs engineering based on the engineering recommendation for the automation function instance of the engineering object 102. The engineering performing module 103D comprises a layout extraction module 103E that obtains a process layout diagram associated with the engineering recommendation, wherein the process layout diagram comprises a plurality of engineering objects 101A-101F in connection with each other. The engineering performing module 103D comprises a position determination module 103F that determines a position of insertion of the engineering object 102 in the process layout diagram. The engineering performing module 103D comprises an object linking module 103G that connects the engineering object 102 in the process layout diagram at the position of insertion.

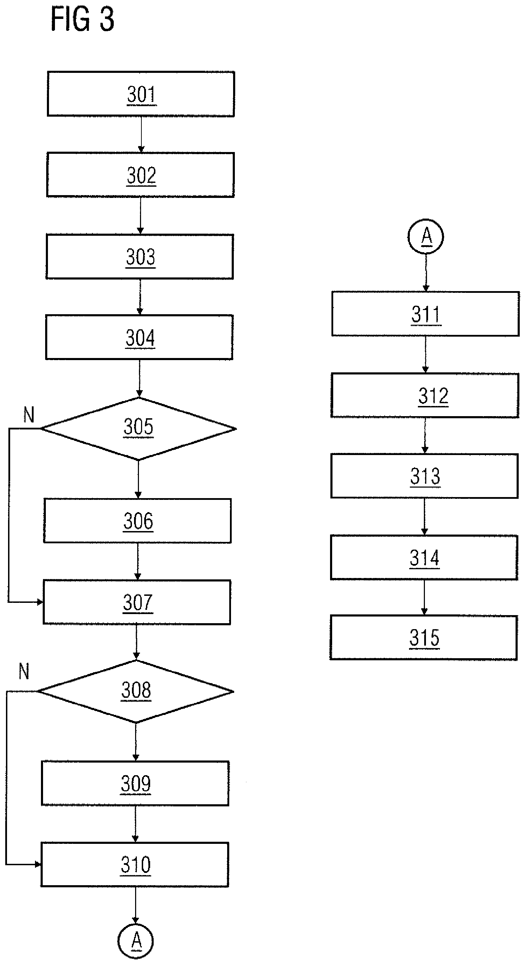

FIG 3 is a process flowchart illustrating an engineering method employing the engineering management system 103 illustrated in FIGS 1 or 2. The engineering method disclosed herein employs the engineering management system 103 illustrated in FIG 2, comprising at least one processor configured to execute computer program instructions for performing steps of the engineering method, disclosed herein. At step 301 of the engineering method, the engineering management system 103 periodically monitors the communication network 104 of the distributed control system 100 illustrated in FIG 1. A user accessing the engineering system 109 illustrated in FIG 1 and/or the distributed control system 100, initiates the engineering method which employs the engineering management system 103, for example, when he/she inserts an engineering object 102 into the communication network 104. The engineering object 102 transmits its token data into the communication network 104. At step 302 of the engineering method, the engineering management system 103 receives the token data from the engineering object 102 and/or communicates with the token database 106 for obtaining the token data based on one or more parameters associated with the engineering object 102 such as a device type. At step 303 of the engineering method, the engineering management system 103 acknowledges insertion of the engineering object 102 into the communication network 104 based on the token data obtained. At step 304 of the engineering method, the engineering management system 103 determines an automation function instance of the engineering object 102 from a plurality of automation function instances stored in an engineering database 105, based on the token data. At step 305, of the engineering method, the engineering management system 103 determines whether more than one automation function instances of the engineering object 102 are present in the engineering database 105. If yes, then at step 306 of the engineering method, the engineering management system 103 receives an input from the user for selection of the automation function instance. If no, then at step 307 of the engineering method, the engineering management system 103 generates an engineering recommendation based on the automation function instance. At step 308 of the engineering method, the engineering management system 103 determines whether the engineering recommendation comprises more than one proposed connections of the automation function instance with other automation function instances. If yes, then at step 309 of the engineering method, the engineering management system 103 receives an input from the user for selection of the proposed connection of the automation function instance with other automation function instances. If no, then at step 310 of the engineering method, the engineering management system 103 renders the engineering recommendation on the graphical user interface (GUI) 103H. At step 311 of the engineering method, the engineering management system 103 displays a proposed connection of the automation function instance with other automation function instances, to the user. At step 312 of the engineering method, the engineering management system 103 obtains a process layout diagram comprising a plurality of engineering objects 101A-101F in connection with each other, associated with the engineering recommendation. At step 313 of the engineering method, the engineering management system 103 determines a position of insertion of the engineering object 102 in the process layout diagram using the engineering recommendation, that is, the connected automation function instance with other automation function instances. At step 314 of the engineering method, the engineering management system 103 connects the engineering object 102 in the process layout diagram at the position of insertion. At step 315 of the engineering method, the engineering management system 103 maintains the engineering recommendation and the process layout diagram in the engineering database 105.

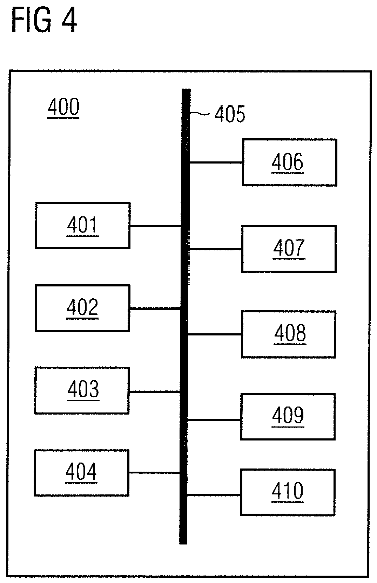

FIG 4 is a block diagram illustrating architecture of a computer system 400 employed by the engineering management system 103 illustrated in FIGS 1 or 2. The engineering management system 103 employs the architecture of the computer system 400 illustrated in FIG 4. The computer system 400 is programmable using a high level computer programming language. The computer system 400 may be implemented using programmed and purposeful hardware. As illustrated in FIG 4, the computer system 400 comprises a processor 401, a non-transitory computer readable storage medium such as a memory unit 402 for storing programs and data, an input/output (I/O) controller 403, a network interface 404, a data bus 405, a display unit 406, input devices 407, a fixed media drive 408 such as a hard drive, a removable media drive 409 for receiving removable media, output devices 410, etc. The processor 401 refers to any one of microprocessors, central processing unit (CPU) devices, finite state machines, microcontrollers, digital signal processors, an application specific integrated circuit (ASIC), a field-programmable gate array (FPGA), etc., or any combination thereof, capable of executing computer programs or a series of commands, instructions, or state transitions. The processor 401 may also be implemented as a processor set comprising, for example, a general purpose microprocessor and a math or graphics co-processor. The processor 401 is selected, for example, from the Intel^{®} processors, Advanced Micro Devices (AMD^{®}) processors, International Business Machines (IBM^{®}) processors, etc. The engineering management system 103 disclosed herein is not limited to a computer system 400 employing a processor 401. The computer system 400 may also employ a controller or a microcontroller. The processor 401 executes the modules, for example, 103A, 103B, 103C, 103D, 103E, 103F, 103G, etc., of the engineering management system 103.

The memory unit 402 is used for storing programs, applications, and data. For example, the connection determination module 103A, the automation function instance management module 103B, the recommendation generation module 103C, engineering performing module 103D, etc., of the engineering management system 103 are stored in the memory unit 402 of the computer system 400. The memory unit 402 is, for example, a random access memory (RAM) or another type of dynamic storage device that stores information and instructions for execution by the processor 401. The memory unit 402 also stores temporary variables and other intermediate information used during execution of the instructions by the processor 401. The computer system 400 further comprises a read only memory (ROM) or another type of static storage device that stores static information and instructions for the processor 401. The I/O controller 403 controls input actions and output actions performed by the engineering management system 103.

The network interface 404 enables connection of the computer system 400 to the communication network 104 and/or 108. For example, the engineering management system 103 connects to the communication network 104 via the network interface 404. In an embodiment, the network interface 404 is provided as an interface card also referred to as a line card. The network interface 404 comprises, for example, interfaces using serial protocols, interfaces using parallel protocols, and Ethernet communication interfaces, interfaces based on wireless communications technology such as satellite technology, radio frequency (RF) technology, near field communication, etc. The data bus 405 permits communications between the modules, for example, 103A, 103B, 103C, 103D, 103E, 103F, 103G, etc., of engineering management system 103.

The display unit 406, via the graphical user interface (GUI) 103H, displays information such as the process layout diagram, the engineering recommendation, the automation function instance, user interface elements such as text fields, buttons, windows, etc., for allowing a user to provide his/her inputs. The display unit 406 comprises, for example, a liquid crystal display, a plasma display, an organic light emitting diode (OLED) based display, etc. The input devices 407 are used for inputting data into the computer system 400. The input devices 407 are, for example, a keyboard such as an alphanumeric keyboard, a touch sensitive display device, and/or any device capable of sensing a tactile input.

Computer applications and programs are used for operating the computer system 400. The programs are loaded into the fixed media drive 408 and into the memory unit 402 of the computer system 400 via the removable media drive 409. In an embodiment, the computer applications and programs may be loaded directly via the communication network 104 and/or 108. Computer applications and programs are executed by double clicking a related icon displayed on the display unit 406 using one of the input devices 407. The output devices 410 output the results of operations performed by the engineering management system 103.

The processor 401 executes an operating system, for example, the Linux^{®} operating system, the Unix^{®} operating system, any version of the Microsoft^{®} Windows^{®} operating system, the Mac OS of Apple Inc., the IBM^{®} OS/2, etc. The computer system 400 employs the operating system for performing multiple tasks. The operating system is responsible for management and coordination of activities and sharing of resources of the computer system 400. The operating system further manages security of the computer system 400, peripheral devices connected to the computer system 400, and network connections. The operating system employed on the computer system 400 recognizes, for example, inputs provided by the users using one of the input devices 407, the output display, files, and directories stored locally on the fixed media drive 408. The operating system on the computer system 400 executes different programs using the processor 401. The processor 401 and the operating system together define a computer platform for which application programs in high level programming languages are written.

The processor 401 of the computer system 400 employed by the engineering management system 103 retrieves instructions defined by the object reception module 102, the dependency determination module 103, the engineering generation module 104, etc., of the engineering management system 103 for performing respective functions disclosed in the detailed description of FIG 2. The processor 401 retrieves instructions for executing the modules, for example, 103A, 103B, 103C, 103D, 103E, 103F, 103G, etc., of the engineering management system 103 from the memory unit 402. A program counter determines the location of the instructions in the memory unit 402. The program counter stores a number that identifies the current position in the program of each of the modules, for example, 103A, 103B, 103C, 103D, 103E, 103F, 103G, etc., of the engineering management system 103. The instructions fetched by the processor 401 from the memory unit 402 after being processed are decoded. The instructions are stored in an instruction register in the processor 401. After processing and decoding, the processor 401 executes the instructions, thereby performing one or more processes defined by those instructions.

At the time of execution, the instructions stored in the instruction register are examined to determine the operations to be performed. The processor 401 then performs the specified operations. The operations comprise arithmetic operations and logic operations. The operating system performs multiple routines for performing a number of tasks required to assign the input devices 407, the output devices 410, and memory for execution of the modules, for example, 103A, 103B, 103C, 103D, 103E, 103F, 103G, etc., of the engineering management system 103. The tasks performed by the operating system comprise, for example, assigning memory to the modules, for example, 103A, 103B, 103C, 103D, 103E, 103F, 103G, etc., of the engineering management system 103, and to data used by the engineering management system 103, moving data between the memory unit 402 and disk units, and handling input/output operations. The operating system performs the tasks on request by the operations and after performing the tasks, the operating system transfers the execution control back to the processor 401. The processor 401 continues the execution to obtain one or more outputs. The outputs of the execution of the modules, for example, 103A, 103B, 103C, 103D, 103E, 103F, 103G, etc., of the engineering management system 103 are displayed to the user on the GUI 103H.

For purposes of illustration, the detailed description refers to the engineering management system 103 being run locally on the computer system 400; however the scope of the present invention is not limited to the engineering management system 103 being run locally on the computer system 400 via the operating system and the processor 401, but may be extended to run remotely over the communication network 104 and/or 108 by employing a web browser and a remote server, or other electronic devices. One or more portions of the computer system 400 may be distributed across one or more computer systems (not shown) coupled to the communication network 104 and/or 108.

Disclosed herein is also a computer program product comprising a non-transitory computer readable storage medium that stores computer program codes comprising instructions executable by at least one processor 401 for performing the engineering method steps using the engineering management system 103, as disclosed in the present invention. In an embodiment, a single piece of computer program code comprising computer executable instructions performs one or more steps of the engineering method according to the present invention. The computer program codes comprising computer executable instructions are embodied on the non-transitory computer readable storage medium. The processor 401 of the computer system 400 retrieves these computer executable instructions and executes them. When the computer executable instructions are executed by the processor 401, the computer executable instructions cause the processor 401 to perform the steps of the method for configuring a protection system of a power network.

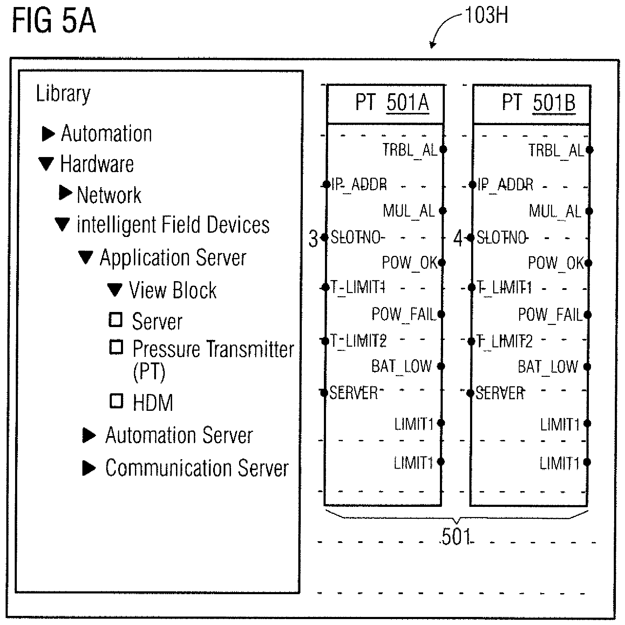

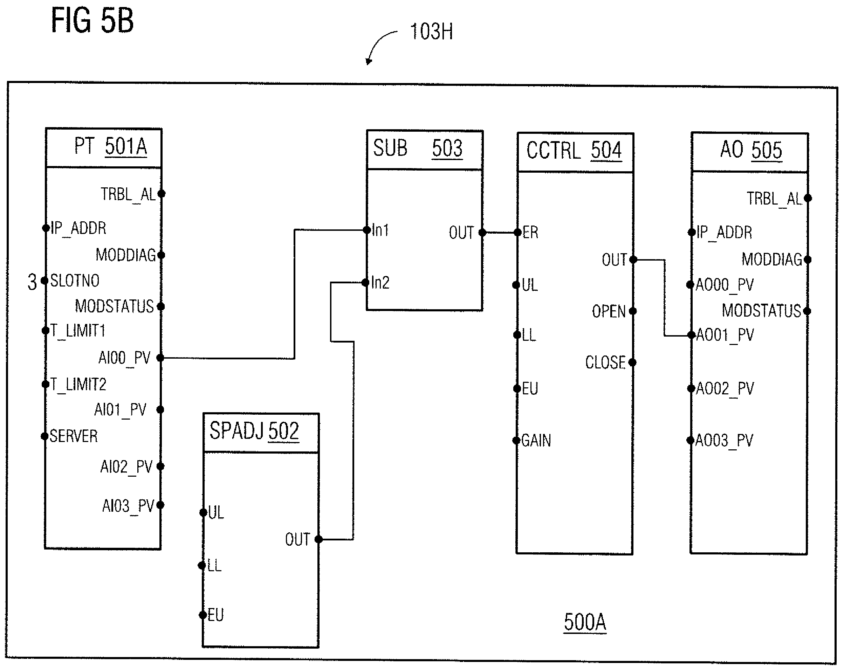

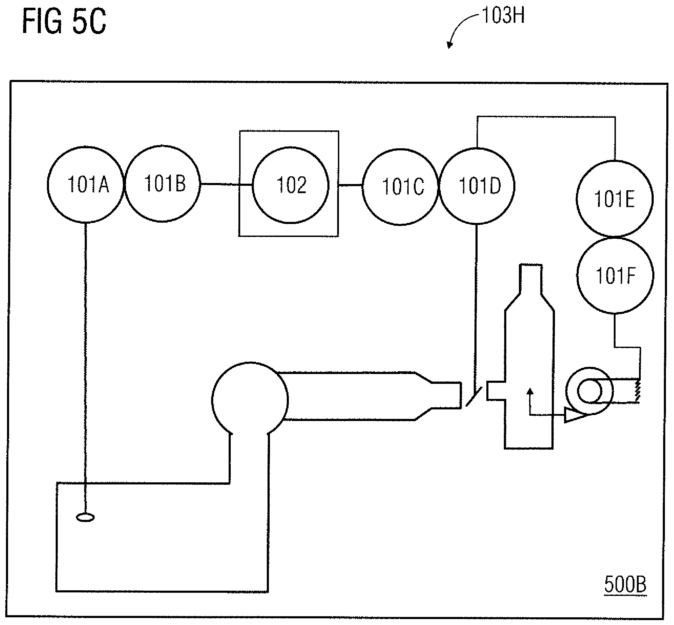

FIGS 5A-5C illustrate screenshots of a graphical user interface (GUI) 103H provided by the engineering management system 103 illustrated in FIGS 1 and 2 on a user device for performing steps of the engineering method disclosed in the detailed description of FIG 3. For example, the FIGS 5A-5C illustrate screenshots of a GUI 103H provided by the engineering management system 103 for performing engineering such as configuring an engineering process including a pressure transmitter 102 in connection with other engineering objects 101A-101H, in a distributed control system 100 illustrated in FIG 1. A user accessing the engineering management system 103 via the GUI 103H inserts a pressure transmitter 102 into the communication network 104. The engineering management system 103 obtains the token data associated with the pressure transmitter 102 and determines an automation function instance 501 for the pressure transmitter 102 based on the token data of the pressure transmitter 102, from the engineering database 105. The token data of the pressure transmitter comprises, for example, 3051C model number, coplanar type of pressure transmitter, -300 to 300 psi, and 4-20mA output. Consider that there exist more than one automation function instances 501A and 501B of the pressure transmitter 102 in the engineering database 105. The engineering management system 103 displays each of these automation function instances 501A and 501B to the user as illustrated in FIG 5A. The user selects one of the automation function instance 501A for configuring the engineering process. The engineering management system 103 generates an engineering recommendation 500A illustrated in FIG 5B and proposes a connection of the automation function instance 501A of the pressure transmitter 102 with other automation function instances 502-505 of other engineering objects 101A-101H. The engineering management system 103 performs engineering based on the engineering recommendation 500A by obtaining a process layout diagram 500B associated with the engineering recommendation 500A, determining a position of insertion of the pressure transmitter 102 in the process layout diagram 500B, and connecting the pressure transmitter 102 in the process layout diagram 500B at the position of insertion, as illustrated in FIG 5C.

It will be readily apparent that the various methods, algorithms, and computer programs disclosed herein may be implemented on computer readable media appropriately programmed for computing devices. As used herein, "computer readable media" refers to non-transitory computer readable media that participate in providing data, for example, instructions that may be read by a computer, a processor or a similar device. Non-transitory computer readable media comprise all computer readable media, for example, non-volatile media, volatile media, and transmission media, except for a transitory, propagating signal.

The computer programs that implement the methods and algorithms disclosed herein may be stored and transmitted using a variety of media, for example, the computer readable media in a number of manners. In an embodiment, hard-wired circuitry or custom hardware may be used in place of, or in combination with, software instructions for implementation of the processes of various embodiments. Therefore, the embodiments are not limited to any specific combination of hardware and software. In general, the computer program codes comprising computer executable instructions may be implemented in any programming language. The computer program codes or software programs may be stored on or in one or more mediums as object code. Various aspects of the method and system disclosed herein may be implemented in a non-programmed environment comprising documents created, for example, in a hypertext markup language (HTML), an extensible markup language (XML), or other format that render aspects of a graphical user interface (GUI) 103H or perform other functions, when viewed in a visual area or a window of a browser program. Various aspects of the method and system disclosed herein may be implemented as programmed elements, or non-programmed elements, or any suitable combination thereof. The computer program product disclosed herein comprises one or more computer program codes for implementing the processes of various embodiments.

Where databases are described such as the engineering database 105 and the token database 106, it will be understood by one of ordinary skill in the art that (i) alternative database structures to those described may be readily employed, and (ii) other memory structures besides databases may be readily employed. Any illustrations or descriptions of any sample databases disclosed herein are illustrative arrangements for stored representations of information. Any number of other arrangements may be employed besides those suggested by tables illustrated in the drawings or elsewhere. Similarly, any illustrated entries of the databases represent exemplary information only; one of ordinary skill in the art will understand that the number and content of the entries can be different from those disclosed herein. Further, despite any depiction of the databases as tables, other formats including relational databases, object-based models, and/or distributed databases may be used to store and manipulate the data types disclosed herein. Likewise, object methods or behaviors of a database can be used to implement various processes such as those disclosed herein. In addition, the databases may, in a known manner, be stored locally or remotely from a device that accesses data in such a database. In embodiments where there are multiple databases in the system, the databases may be integrated to communicate with each other for enabling simultaneous updates of data linked across the databases, when there are any updates to the data in one of the databases.

The present invention can be configured to work in a network environment comprising one or more computers that are in communication with one or more devices via a network. The computers may communicate with the devices directly or indirectly, via a wired medium or a wireless medium such as the Internet, a local area network (LAN), a wide area network (WAN) or the Ethernet, a token ring, or via any appropriate communications mediums or combination of communications mediums. Each of the devices comprises processors, some examples of which are disclosed above, that are adapted to communicate with the computers. In an embodiment, each of the computers is equipped with a network communication device, for example, a network interface card, a modem, or other network connection device suitable for connecting to a network. Each of the computers and the devices executes an operating system, some examples of which are disclosed above. While the operating system may differ depending on the type of computer, the operating system will continue to provide the appropriate communications protocols to establish communication links with the network. Any number and type of machines may be in communication with the computers.

The present invention is not limited to a particular computer system platform, processor, operating system, or network. One or more aspects of the present invention may be distributed among one or more computer systems, for example, servers configured to provide one or more services to one or more client computers, or to perform a complete task in a distributed system. For example, one or more aspects of the present invention may be performed on a client-server system that comprises components distributed among one or more server systems that perform multiple functions according to various embodiments. These components comprise, for example, executable, intermediate, or interpreted code, which communicate over a network using a communication protocol. The present invention is not limited to be executable on any particular system or group of systems, and is not limited to any particular distributed architecture, network, or communication protocol.

The foregoing examples have been provided merely for the purpose of explanation and are in no way to be construed as limiting of the present invention disclosed herein. While the invention has been described with reference to various embodiments, it is understood that the words, which have been used herein, are words of description and illustration, rather than words of limitation. Further, although the invention has been described herein with reference to particular means, materials, and embodiments, the invention is not intended to be limited to the particulars disclosed herein; rather, the invention extends to all functionally equivalent structures, methods and uses, such as are within the scope of the appended claims. Those skilled in the art, having the benefit of the teachings of this specification, may affect numerous modifications thereto and changes may be made without departing from the scope and spirit of the invention in its aspects.

### List of reference numerals

- 100: distributed control system
- 101A-101H: engineering objects
- 102: engineering object (new)
- 103: engineering management system
- 103A: connection determination module
- 103B: automation function instance management module
- 103C: recommendation generation module
- 103D: engineering performing module
- 103E: layout extraction module
- 103F: position determination module
- 103G: object linking module
- 103H: graphical user interface (GUI)
- 104, 108: communication network
- 105: engineering database
- 106: token database
- 107: external sources
- 109: engineering system
- 301-315: engineering method steps
- 401: processor
- 402: memory unit
- 403: I/O controller
- 404: network interface
- 405: data bus
- 406: display unit
- 407: input devices
- 408: fixed media drive
- 409: removable media drive
- 410: output devices
- 500A: engineering recommendation
- 500B: process layout diagram
- 501, 501A, 501B: automation function instance of the (new) engineering object
- 502-505: automation function instances

## Claims

1. An engineering method employing an engineering management system (103), said engineering method comprising:
determining a connection of at least one engineering object (102) into a communication network (104) of a plurality of engineering objects (101A-101F) by obtaining token data associated with said at least one engineering object (102);
determining an automation function instance (501) of said at least one engineering object (102), from a plurality of automation function instances (501-505) stored in an engineering database (105), based on said token data;
generating an engineering recommendation (500A) based on said automation function instance (501), wherein said engineering recommendation (500A) comprises proposed connections of said automation function instance (501) with other said automation function instances (502-505); and
performing engineering based on said engineering recommendation (500A) for said automation function instance (501) of said at least one engineering object (102) using said engineering management system (103).

2. The method according to claim 1, wherein said token data comprises data associated with one or more of configuration and manufacturing of said engineering object (102).

3. The method according to claim 1 or 2, further comprising creating an automation function instance (501) based on said token data, when said automation function instance (501) for said at least one engineering object (102) is absent in said engineering database (105).

4. The method according to any of the preceding claims, further comprising recommending an alternative automation function instance, when said automation function instance (501) for said at least one engineering object (102) is absent in said engineering database (105).

5. The method according to any of the preceding claims, wherein said performing of said engineering based on said engineering recommendation (500A) comprises:
obtaining a process layout diagram (500B) associated with said engineering recommendation (500A), wherein said process layout diagram (500B) comprises a plurality of engineering objects (101A-101F) in connection with each other;
determining a position of insertion of said at least one engineering object (102) in said process layout diagram (500B) using said engineering recommendation (500A); and
connecting said at least one engineering object (102) in said process layout diagram (500B) at said position of insertion.

6. An engineering management system (103) comprising:
a token database (106) configured to store token data associated with an engineering object (101A-101F, 102), said token database (106) in communication with a plurality of external sources (107) via a communication network (108);
a non-transitory computer readable storage medium storing computer program instructions defined by modules of said engineering management system (103);
at least one processor communicatively coupled to said non-transitory computer readable storage medium, said at least one processor executing said defined computer program instructions; and
said modules of said engineering management system (103) comprising:
a connection determination module (103A) configured to determine connection of at least one said engineering object (102) into said communication network (104) of a plurality of engineering objects (101A-101F) by obtaining said token data;
an automation function instance management module (103B) configured to determine an automation function instance (501) of said at least one engineering object (102), from a plurality of automation function instances (501-505) stored in an engineering database (105), based on said token data;
a recommendation generation module (103C) configured to generate an engineering recommendation (500A) based on said automation function instance (501), wherein said engineering recommendation (500A) comprises proposed connections of said automation function instance (501) with other said automation function instances (502-505); and
an engineering performing module (103D) configured to perform engineering based on said engineering recommendation (500A) for said automation function instance (501) of said engineering object (102).

7. The engineering management system according to claim 6, wherein said token data comprises data associated with one or more of configuration and manufacturing of said engineering object (102).

8. The engineering management system according to claim 6 or 7, wherein said automation function instance management module (103B) is further configured to create an automation function instance (501), when said automation function instance (501) for said at least one engineering object (102) is absent in said engineering database (105).

9. The engineering management system according to any of the claims 6 to 8, wherein said automation function instance management module (103B) is further configured to recommend an alternative automation function instance, when said automation function instance (501) for said at least one engineering object (102) is absent in said engineering database (105).

10. The engineering management system according to any of the claims 6 to 9, wherein said engineering performing module (103D) further comprises:
a layout extraction module (103E) configured to obtain a process layout diagram (500B) associated with said engineering recommendation (500A), wherein said process layout diagram (500B) comprises a plurality of engineering objects (101A-101F) in connection with each other;
a position determination module (103F) configured to determine a position of insertion of said at least one engineering object (102) in said process layout diagram (500B); and
an object linking module (103G) configured to connect said at least one engineering object (102) in said process layout diagram (500B) at said position of insertion.

11. An engineering system (109) comprising:
an engineering management system (103) with a token database (106) according to claims 6 to 10;
an engineering database (105), connected to said engineering management system (103) via a communication network (104); and
a plurality of external sources (107), connected to said token database (106) of said engineering management system (103) via a communication network (108).

12. A distributed control system (100) comprising:
an engineering system (109) according to claim 11; and
a plurality of engineering objects (101A-101F, 102) in connection with one another and with said engineering system (109) via said communication network (104).

13. A distributed control system (100) comprising:
an engineering management system (103) according to claims 6 to 10;
an engineering database (105) connected to said engineering management system (103) via a communication network (104);
a plurality of external sources (107) connected to said token database (106) of said engineering management system (103) via a communication network (108); and
a plurality of engineering objects (101A-101F, 102) in connection with one another and with said engineering management system (103) via said communication network (104).

14. A computer program product comprising a non-transitory computer readable storage medium, said non-transitory computer readable storage medium storing computer program codes that comprise instructions executable by at least one processor for performing the engineering method steps according to any of the claims 1-5.
